# EUROPEAN PATENT APPLICATION

(11) **EP 1 237 184 A1**
(43) Date of publication of application: **04.09.2002**
(21) Application number: 00979095.7
(22) Date of filing: 05.12.2000
(51) Int. Cl.: H01L 21/56, B29C 43/18, B29C 43/32

(54) **MOLD RELEASE FILM FOR SEALING SEMICONDUCTOR ELEMENT AND SEALING METHOD FOR SEMICONDUCTOR ELEMENT USING IT**

(30) Priority: 06.12.1999 JP 34583599
(71) Applicant: IDEMITSU PETROCHEMICAL CO., LTD., Tokyo 130-0015 (JP)
(72) Inventor: OTSUKI, Yusuke, Ichihara-shi, Chiba 299-0107 (JP); YAMATO, Hiroyasu, Sumida-ku, Tokyo 130-0015 (JP); ISOGAI, Osamu, Sumida-ku, Tokyo 130-0015 (JP)
(74) Representative: Gille Hrabal Struck Neidlein Prop Roos
(86) International application number: JP0008600
(87) International publication number: WO01043182

(57) **Abstract**

Provided by the present invention is a mold release film for sealing a semiconductor element, which does not deform or cause deformation of the terminals of the semiconductor and which has good releasability during the semiconductor element sealing process, and a sealing method for a semiconductor element using the mold release film, which can improve efficiency of manufacturing a semiconductor. Disclosed is a mold release film for sealing a semiconductor element, comprising a single layer or a plurality of layers containing a thermoplastic resin and satisfying the following (1)-(4) requirements, and a sealing method for a semiconductor element using the mold release film:
(1) a wetting index of a front surface layer of the mold release film is 36 or less;
(2) a heat shrinkage rate of the mold release film at 175°C is less than 3 percent;
(3) a modulus of elasticity of the mold release film at 175°C is in the range of 10-500 MPa; and
(4) a thickness of the mold release film is in the range of 10-300 µm.

## Description

### TECHNICAL FIELD

The present invention relates a mold release film for sealing a semiconductor element and a sealing method for a semiconductor element using the release film. Specifically, the present invention relates to a mold release film for a sealing semiconductor element, which is used in a resin-sealing process in a sealing method for a semiconductor element by the compression molding, and a sealing method for a semiconductor element using the release film.

### BACKGROUND OF THE INVENTION

New methods for the production of semiconductors have been being developed so as to improve manufacturing efficiency thereof. For example, as is described in Japanese Patent Application Laid-open (kokai) Nos. 10(1998)-125705, 10(1998)-79362, etc., there has been developed a semiconductor sealing method in which LSIs mounted on a wafer are compression-molded into a micro package while the wafer is retained. This method comprises placing a thermoplastic epoxy resin on a wafer on which many LSIs are mounted, and compression molding the wafer with the resin being placed thereon in a mold while heating it, thereby to seal the whole wafer with the resin. In this method, a mold release film, such as that of a polyimide, polyvinyl chloride, polycarbonate (PC), polyethyleneterephthalate (PET), etc., is used to be interposed between the mold and the sealing thermoplastic epoxy resin, and the same kind of release film is used to be interposed between the mold and the wafer or a flexible board. The release film is used as a production process film, for example, in such a manner that it is interposed between the mold and the resin of the board during the production of printed-circuit boards through contact bonding for the purpose of preventing bonding between the mold and the resin of the board.

However, there are some drawbacks in using the release films, such as those made of a polyimide, polycarbonate, etc., as conventionally used in the sealing process in the semiconductor production method. Specifically, such films exhibit high stiffness at a temperature at which the epoxy resin is hardened, which may result in deformation of the terminals (i.e., the projecting electrodes) of the semiconductor, and polyimide films are expensive. Further, there is a risk that the release films, such as those made of polyvinyl chloride and polycarbonate, deform and shrink at a temperature at which the epoxy resin is hardened, which may prevent reliable sealing. Still further, if the release film made of PET is employed, adhesion may occur when the epoxy resin is hardened, resulting in difficulty of release from the mold. In summary, using those known release films causes troubles in the semiconductor production process and generation of defectives, resulting in reduction of manufacturing efficiency.

Therefore, there is the need for a novel release film for sealing semiconductor elements which is low-cost, does not deform or cause deformation of the terminals of the semiconductors, and which has good releasability and enables the production of semiconductors without generating defectives, and for a novel method of sealing semiconductor elements exhibiting the above advantages.

### DISCLOSURE OF THE INVENTION

It is an object of the present invention to provide a mold release film for a sealing semiconductor element, which does not deform or cause deformation of the terminals of the semiconductor and which has good releasability, and a sealing method for a semiconductor element using the release film, which can improve efficiency of manufacturing a semiconductor.

The inventors of the present invention have found, through extensive studies, that the object of the present invention can be effectively achieved by the use of a mold release film which has specific physical properties and the like. The present invention has been made based on the above finding. Specifically, the gist of the present invention is as follows.
1. A mold release film for sealing a semiconductor element, comprising a single layer or a plurality of layers containing a thermoplastic resin, and satisfying the following (1)-(4) requirements:
   (1) a wetting index of the front surface layer of the mold release film is 36 or less;
   (2) a heat shrinkage rate of the mold release film at 175°C is less than 3 percent;
   (3) a modulus of elasticity of the mold release film at 175°C is in the range of 10-500 MPa; and
   (4) a thickness of the mold release film is in the range of 10-300 µ m.
2. A mold release film for sealing a semiconductor element as set forth in item 1, wherein at least a surface layer of the mold release film comprises (A) a fluorine resin, (B) a styrene polymer having predominantly a syndiotactic structure or (C) a resin composition containing a styrene polymer having predominantly a syndiotactic structure.
3. A mold release film for sealing a semiconductor element as set forth in item 2, wherein (C) the resin composition containing a styrene polymer having predominantly a syndiotactic structure comprises 50 wt.% or more but less than 100 wt.% of a styrene polymer having predominantly a syndiotactic structure, and not greater than 50 wt.% but more than 0 wt.% of at least one component selected from the group consisting of (C-1) a rubber-like elastic material, (C-2) a thermoplastic resin other than the styrene polymer having predominantly a syndiotactic structure and (C-3) an additive for the resin composition.
4. A sealing method for a semiconductor element comprising placing a semiconductor board, on which a semiconductor element with projecting electrodes is mounted, in a semiconductor production mold in which at least one release film is arranged, and thereafter supplying a sealing resin to the mold to carry out compression molding, wherein the mold release film for sealing a semiconductor element as set forth in any one of items 1-3 is used as the at least one release film arranged in the mold.

### BRIEF DESCRIPTION OF THE DRAWINGS

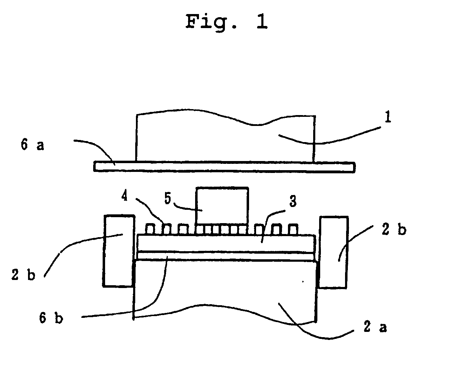

Figure 1 is a conceptional view (a cross-sectional view) showing a mold for sealing semiconductor elements, which can be used in the sealing method of the present invention.

Explanation of Reference Numerals:
- 1:: upper mold half
- 2:: lower mold half
- 3:: semiconductor board
- 4:: projecting electrode (bump)
- 5:: sealing resin
- 6a, 6b:: release film for sealing semiconductor element

### BEST MODE FOR CARRING OUT THE INVENTION

The best mode for carrying out the present invention will hereinbelow be described.

### Release Film For Sealing Semiconductor Element

The present invention provides a mold release film for a sealing semiconductor element, comprising a single layer or a plurality of layers containing a thermoplastic resin, and satisfying the following Requirements (1)-(4):
(1) a wetting index of a surface layer of the mold release film is 36 or less;
(2) a heat shrinkage rate of the mold release film at 175°C is less than 3 percent;
(3) a modulus of elasticity of the mold release film at 175°C is in the range of 10-500 MPa; and
(4) a thickness of the mold release film is in the range of 10-300 µ m.

Each of the above requirements will hereinbelow be described.

Regarding Requirement (1), a wetting index of the surface layer must be 36 or less, preferably 35 or less. If the wetting index of the surface layer exceeds 36, the releasability of the release film with respect to the sealing resin will become poor, which may cause troubles in the releasing process after the application of the releasing resin.

Regarding Requirement (2), a heat shrinkage rate of the release film at 175°C must be less than 3 percent, preferably less than 2 percent. If the heat shrinkage rate at 175°C exceeds 3 percent, the release film will highly shrink at the time of sealing the semiconductor element, which may cause separation between the sealing resin and the release film, and the sticking of the release film to the mold may occur, which is disadvantageous.

Regarding Requirement (3), a modulus of elasticity of the release film at 175°C must be in the range of 10-500 MPa, preferably in the range of 50-300 MPa. If the modulus of elasticity of the release film at 175°C is less than 10 MPa, the release film will be too infirm, resulting in poor handleability when the mold is opened after the sealing and the molded product is taken out from the mold. On the other hand, if the modulus of elasticity of the release film at 175°C exceeds 500 MPa, deformation of the terminals of the semiconductor may occur.

Regarding Requirement (4), a thickness of the release film must be in the range of 10-300 µ m, preferably in the range of 50-100 µ m. If the thickness of the release film is less than 10 µ m, the release film will be infirm, resulting in difficulty in handling of the film. If the thickness of the release film exceeds 300 µ m, heat conduction from the mold through the film will become poor and thus it will take longer time to carry out molding, which will render the film unsuitable for a release film for sealing a semiconductor element according to the present invention.

The release film satisfying the above Requirements (1)-(4) has good releasability with respect to a semiconductor production mold. Hence, such a release film is easily released from the mold when the mold is opened after the formation of the sealing resin layer. Further, such a release film is not thermally fused to the sealing resin and is easily separated therefrom. Still further, referring to the above-mentioned release film which is disposed between the projecting electrode and the mold, it has such a flexibility and a thickness that do not cause the projecting electrode to deform, whereby occurrence of troubles, such as the generation of defectives during the semiconductor production process, can be suppressed.

The mold release film for sealing a semiconductor element satisfying the above-described requirements according to the present invention is preferably made of the following materials.

First, the mold release film for a sealing semiconductor element according to the present invention is preferably such that at least a surface layer thereof comprises (A) a fluorine resin, (B) a styrene polymer having predominantly a syndiotactic structure or (C) a resin composition containing a styrene polymer having predominantly a syndiotactic structure.

In other words, if the release film having a single layer is to be made, using any one of the resins (A) and (B) and the resin composition (C) is sufficient. If the release film having a plurality of layers is to be made, two or more of the resins (A) and (B) and the resin composition (C) may be used, or any one or more of the resins (A) and (B) and the resin composition (C) may be superimposed on a thermoplastic resin other than the materials (A)-(C) in such a manner that any one of the resins (A) and (B) and the resin composition (C) is used as a surface layer (i.e., the outermost layer).

The materials (A)-(C) and the thermoplastic resin other than the materials (A)-(C) as used in the present invention include the following.

### (A) Fluorine Resin

The fluorine resin which may be used in the present invention is a synthetic resin which is obtained by polymerization of olefins containing fluorine. Examples of the fluorine resin include polytetrafluoroethylene, an ethylene-tetrafluoroethylene copolymer, a propylene-tetrafluoroethylene copolymer, polychlorotrifluoroethylene, polydichlorodifluoroethylene, polyvinylidene fluoride, etc.

### (B) STYRENE POLYMER HAVING PREDOMINANTLY SYNDIOTACTIC STRUCTURE

The syndiotactic structure in the styrene polymer having predominantly a syndiotactic structure as used in the present invention (which may hereinafter be referred to as SPS) means a stereostructure in which the stereochemical structure of SPS is a syndiotactic configuration, that is, phenyl groups constituting the side chains are positioned alternately on opposite sides with respect to the main chain composed of carbon-carbon linkages. The tacticity is quantified by the nuclear magnetic resonance method using isotopic carbon atoms (i.e., ¹³C-NMR method). The tacticity as measured by ¹³C-NMR method is indicated by the proportion of a building block consisting of a plurality of base units, for example, a diad in the case where the building block consists of two base units, a triad in the case where the building block consists of three base units, and a pentad in the case where the building block consists of five base units. Examples of the styrene polymer having predominantly a syndiotactic structure as used in the present invention include polystyrene, poly(alkyl styrene), poly(halogenated styrene), poly(halogenated alkyl styrene), poly(alkoxy styrene), poly(vinyl benzoate), hydrogenated polymers thereof, mixtures thereof and copolymers each comprising any of these as a main component, all having a syndiotacticity of generally 75 % or more, preferably 85 % or more, in terms of racemic diads, or 30 % or more, preferably 50 % or more, in terms of racemic pentads. Examples of poly(alkyl styrene) include poly(methyl styrene), poly(ethyl styrene), poly(isopropyl styrene), poly(tertiary butyl styrene), poly(phenyl styrene), poly(vinyl naphthalene), poly(vinyl styrene), etc. Examples of poly(halogenated styrene) include poly(chlorostyrene), poly(bromostyrene), poly(fluorostyrene), etc. Examples of poly(halogenated alkyl styrene) include poly(chloromethyl styrene), etc. Examples of poly(alkoxy styrene) include poly(methoxy styrene), poly(ethoxy styrene), etc.

Examples of particularly preferred styrene polymers include polystyrene, poly(p-methyl styrene), poly(m-methyl styrene), poly(p-tertiary-butyl styrene), poly(p-chlorostyrene), poly(m-chlorostyrene), poly(p-fluorostyrene), hydrogenated polystyrene, and copolymers having those structural units.

The styrene polymer having predominantly a syndiotactic structure can be produced by, for example, polymerizing styrene monomers corresponding to the above-described styrene polymers, using a condensation product of (i) a titanium compound and water and (ii) a trialkyl aluminum as a catalyst, in an inert hydrocarbon solvent or in the absent of any solvent, as described in Japanese Patent Application Laid-open (kokai) No. 62(1987)-187708. Further, poly(halogenated alkyl styrene) can be obtained by, for example, the method described in Japanese Patent Application Laid-open (kokai) No. 1(1989)-46912, and hydrogenated polymers thereof can be obtained by, for example, the method described in Japanese Patent Application Laid-open (kokai) No. 1(1989)-178505.

The styrene polymer having predominantly a syndiotactic structure may be used singly or in combination between two or more among those listed above.

### (C) RESIN COMPOSITION CONTAINING STYRENE POLYMER HAVING PREDOMINANTLY SYNDIOTACTIC STRUCTURE

The resin composition containing the styrene polymer having predominantly a syndiotactic structure as used in the present invention may include, in addition to the styrene polymer having predominantly a syndiotactic structure, at least one component among (C-1) a rubber-like elastic material, (C-2) a thermoplastic resin other than the syndiotactic polystyrene and (C-3) various kinds of additives for the resin composition. Examples of the various kinds of additives for the resin composition which may be used in the present invention include an anti-blocking agent, an antioxidant, a nucleating agent, an antistatic agent, a process oil, a plasticizer, a releasing agent, a flame-retardant, a flame-retarding assistant, a pigment.

Each of the components which may be used in the resin composition containing the styrene polymer having predominantly a syndiotactic structure will hereinbelow be described.

### (C-1) RUBBER-LIKE ELASTIC MATERIAL

Examples of the rubber-like elastic material which may be used in the present invention include natural rubber, polybutadiene, polyisoprene, polyisobutylene, neoprene, polysulfide rubber, Thiokol rubber, acrylic rubber, urethane rubber, silicone rubber, epichlorohydrin rubber, a styrene-butadiene block copolymer (SBR), a hydrogenated styrene-butadiene block copolymer (SEB), a styrene-butadiene-styrene block copolymer (SBS), a hydrogenated styrene-butadiene-styrene block copolymer (SEBS), a styrene-isoprene block copolymer (SIR), a hydrogenated styrene-isoprene block copolymer (SEP), a styrene-isoprene-styrene block copolymer (SIS), a hydrogenated styrene-isoprene-styrene block copolymer (SEPS), olefin rubbers, such as ethylene propylene rubber (EPM), ethylene propylene diene rubber (EPDM) and straight-chain low-density polyethylene elastomers, particulate elastic materials of core shell type, such as butadiene-acrylonitrile-styrene core shell rubber (ABS), methyl methacrylate-butadiene-styrene core shell rubber (MBS), methyl methacrylate-butyl acrylate-styrene core shell rubber (MAS), octyl acrylate-butadiene-styrene core shell rubber (MABS), alkyl acrylate-butadiene-acrylonitrile-styrene core shell rubber (AABS), butadiene-styrene core shell rubber (SBR) and siloxane-containing core shell rubbers, such as those of methyl methacrylate-butyl acrylate-siloxane, and their modified rubbers.

Among those listed above, SBR, SEB,SBS, SEBS, SIR, SEP, SIS, SEPS, core shell rubbers, EPMS, EPDM, straight-chain low-density polyethylene elastomers, and modified rubbers thereof are preferably used from the viewpoint of obtaining the wetting index and film impact as intended according to the present invention.

### (C-2) THERMOPLASTIC RESIN OTHER THAN SYNDIOTACTIC POLYSTYRENE

Examples of the thermoplastic resin other than the syndiotactic polystyrene which may be used in the present invention include polyolefin resins, such as straight-chain high-density polyethylene, straight-chain low-density polyethylene, high-pressure low-density polyethylene, isotactic polypropylene, syndiotactic polypropylene, block polypropylene, random polypropylene, polybutene, 1,2-polybutadiene, 4-methyl pentene, cyclic polyolefins, and copolymers thereof; polystyrene resins, such as atactic polystyrene, isotactic polystyrene, high-impact polystyrene (HIPS), ABS resin, AS resin, a styrene-methacrylic acid copolymer, a styrene-alkyl methacrylate copolymer, a styrene-glycidyl methacrylate copolymer, a styrene-acrylic acid copolymer, a styrene-alkyl acrylate copolymer, a styrene-maleic acid copolymer and a styrene-fumaric acid copolymer; polyester resins, such as polycarbonate, polyethylene terephthalate and polybutylene terephthalate; polyamide resins, such as nylon 6 and nylon 6, 6; polyphenylene ethers; polyphenylene sulfide (PPS); and the like. These thermoplastic resins may be used singly or in combination between two or more thereamong.

In cases where two or more kinds of the thermoplastic resins other than the syndiotactic polystyrene are used, there is no limitation on the respective amounts at which they are incorporated into the resin composition, and these amounts may be appropriately decided, depending on each use.

### (C-3) ADDITIVES FOR RESIN COMPOSITION

Various kinds of additives exemplified below may be incorporated into the resin composition as used in the present invention in usual proportions.

### (a) ANTI-BLOCKING AGENT (AB AGENT)

Examples of the anti-blocking agent include inorganic and organic particles as listed below.

Examples of the inorganic particle include particles of oxides, hydroxides, sulfides, nitrides, halides, carbonates, sulfates, acetates, phosphates, phosphites, organic carboxylates, silicates, titanates and borates of elements of I A Group, II A Group, IV A Group, VI A Group, VII A Group, VIII Group, I B Group, II B Group, III B Group and IV B Group of the Periodic Table, hydrous compounds thereof, composite compounds having centers composed thereof; and particles of natural minerals.

Specifically, examples of the inorganic particle include particles of compounds of I A Group elements of the Periodic Table, such as lithium fluoride and borax (hydrous sodium borate); particles of compounds of II A Group elements of the Periodic Table, such as magnesium carbonate, magnesium phosphate, magnesium oxide (magnesia), magnesium chloride, magnesium acetate, magnesium fluoride, magnesium titanate, magnesium silicate, hydrous magnesium silicate (talc), calcium carbonate, calcium phosphate, calcium phosphite, calcium sulfate (gypsum), calcium acetate, calcium terephthalate, calcium hydroxide, calcium silicate, calcium fluoride, calcium titanate, strontium titanate, barium carbonate, barium phosphate, barium sulfate and barium sulfite; particles of compounds of IV A Group elements of the Periodic Table, such as titanium dioxide (titania), titanium monoxide, titanium nitride, zirconium dioxide (zirconia) and zirconium monoxide; particles of compounds of VI A Group elements of the Periodic Table, such as molybdenum dioxide, molybdenum trioxide and molybdenum sulfide; particles of compounds of VII A Group elements of the Periodic Table, such as manganese chloride and manganese acetate; particles of compounds of VIII Group elements of the Periodic Table, such as cobalt chloride and cobalt acetate; particles of compounds of I B Group elements, such as cuprous iodide; particles of compounds of II B Group elements of the Periodic Table, such as zinc oxide and zinc acetate; particles of compounds of III B Group elements of the Periodic Table, such as aluminum oxide (alumina), aluminum hydroxide, aluminum fluoride and alumina silicate (alumina silicate, kaolin, kaolinite); particles of compounds of IV B Group elements of the Periodic Table, such as silicon oxide (silica, silica gel), black lead, carbon, graphite and glass; and particles of natural minerals, such as carnallite, kainite, mica (mica, phlogopite) and pyrolusite.

Examples of the organic particle include fluorine resins, melamine resins, a styrene-divinyl benzene copolymer, acrylic resin silicone, and crosslinked derivatives thereof.

The average particle diameter of the inorganic particles is preferably in the range of 0.1 µm-10 µm. The amount at which the inorganic particles are incorporated into the resin composition is preferably in the range of 0.01 wt.%-15 wt.%.

These inorganic fillers may be used singly or in combination between two or more thereamong.

### (b) ANTIOXIDANT

The antioxidant which may be used in the present invention can be arbitrarily selected from known antioxidants, such as those of phosphorus type, phenol type, sulfur type, and the like. The antioxidants may be used singly or in combination between two or more thereamong. Specifically, 2-[1-hydroxy-3, 5-di-(t-pentyl phenyl) ethyl]-4, 6-di-t-pentyl phenyl acrylate may be preferably used as the antioxidant.

### (c) NUCLEATING AGENT

The nucleating agent which may be used in the present invention can be arbitrarily selected from known nucleating agents, such as metal salts of carboxylic acids, such as aluminum di-(p-t-butyl benzoate); metal salts of phosphoric acids, such as methylene-bis-(2,4-di-t-butyl phenol) acid sodium phosphate; talc; phthalocyanine derivatives; and the like. These nucleating agents may be used singly or in combination between two or more thereamong.

### (d) PLASTICIZER

The plasticizer which may be used in the present invention can be arbitrarily selected from known plasticizers, such as polyethylene glycol, polyamide oligomers, ethylene-bis-stearamide, phthalic esters, a polystyrene oligomer, polyethylene wax, liquid paraffin, silicone oil, and the like. These plasticizers may be used singly or in combination between two or more thereamong.

### (e) RELEASING AGENT

The releasing agent which may be used in the present invention can be arbitrarily selected from known releasing agents, such as polyethylene wax, silicone oil, long chain carboxylic acids, metal salts of long chain carboxylic acids, and the like. These releasing agents may be used singly or in combination between two or more thereamong.

The resin composition containing the styrene polymer having predominantly a syndiotactic structure for use in the production of the release film for sealing semiconductor elements according to the present invention is produced through the use of at least one of the components (C-1)-(C-3), along with the styrene polymer having predominantly a syndiotactic structure. The styrene polymer having predominantly a syndiotactic structure is used in an amount of 50 wt.% or more but less than 100 wt.%, preferably in an amount of 50-98 wt.%, and more preferably in an amount of 55-95 wt.%. The at least one of the components (C-1)-(C-3) is used in an amount of not greater than 50 wt.% but more than 0 wt.%, preferably in an amount of 50-2 wt. %, and more preferably in an amount of 45-5 wt.%.

If the styrene polymer having predominantly a syndiotactic structure is used in an amount of less than 50 wt.%, the obtained release film may have insufficient heat resistance and poor releasability at the time of compression molding, which is undesirable.

Kneading of the components described above may be carried out in various ways, such as (i) the way in which such components are blended, and then melted and kneaded in a certain step during the syndiotactic polystyrene production process, (ii) the way in which respective components making up the resin composition are blended, and then melted and kneaded, and (iii) the way in which the above components are dry-blended at the time of molding the release film, and then kneaded in the extruder of a molding machine.

### (D) THERMOPLASTIC RESIN OTHER THAN MATERILAS (A)-(D)

Examples of the thermoplastic resin other than the materials (A)-(C), which may be used in the release film for sealing semiconductor elements according to the present invention, include, but are not limited to, polyethylene terephthalate resin, polyethylene naphthalate resin, polyimide resins (nylon), poly(4-methyl pentene-1) resin, etc. It is preferred that these thermoplastic resins other than the materials (A)-(C) are used as an inside layer, not the surface layer, of the release film.

Examples of the method of producing the release film for sealing a semiconductor element according to the present invention, using the reins and/or the resin composition obtained in the above-mentioned manner, include, but are not limited to, the cast molding method, the inflation molding method and the biaxial stretching molding method. In some cases, adjusting the stretching rate is preferred in order to control the modulus of elasticity of the obtained release film so that it is within the given range defined in the present invention. Heat treatment may be applied to the release film in order to control the heat shrinkage rate.

The release film according to the present invention is suitable for a release film for use in sealing a semiconductor element by the compression molding method. Especially, the release film according to the present invention is suitable for a release film for use in the resin sealing process for a semiconductor element having a chip-sized package structure.

### Sealing Method For a Semiconductor Element

The sealing method for a semiconductor element according to the present invention will hereinbelow be described.

The present invention is directed to a sealing method for a semiconductor element comprising placing a semiconductor board, on which a semiconductor element with projecting electrodes is mounted, in a mold for sealing the semiconductor element in which at least one mold release film is arranged, and thereafter supplying a sealing resin to the mold to carry out compression molding, wherein the release film for sealing the semiconductor element as described above is used as the at least one release film arranged in the mold.

The semiconductor production process generally requires the steps of formation of the semiconductor element, formation of projecting electrodes (i.e., bumps), sealing using a resin, exposure of the projecting electrodes and separation. The step of sealing using a resin comprises the steps of installation of the board, formation of a resin layer and releasing. A typical example of the step of sealing using a resin will be explained with reference to the drawing.

Fig. 1 illustrates a conceptional view (a cross-sectional view) showing a mold for sealing a semiconductor element which can be used in the sealing method according to the present invention.

In Fig. 1, reference numeral 1 denotes an upper mold half, reference numerals 2a and 2b denote a lower mold half, reference numeral 3 denotes a semiconductor board, reference numeral 4 denotes a projecting electrode (i.e., a bump), reference numeral 5 denotes a sealing resin, and reference numerals 6a and 6b denote mold release films for a semiconductor element. In this respect, the release film 6b is not necessarily required. The lower mold half is composed of a lower mold half base 2a and lower mold half side members 2b. The lower half mold side members 2b are capable of moving up and down together with the upper mold half 1. Both of the upper mold half and the lower mold half are provided with heaters therein.

The step of sealing using a resin is conducted in the following manner, using the above-explained mold for sealing the semiconductor element.

First, the semiconductor board 3 (i.e., a wafer), on which many semiconductor elements are formed through the semiconductor element formation step and the bump formation step, is placed on the lower mold half 2a of the mold for sealing the semiconductor elements, with the projecting electrodes 4 being positioned on the upper side of the semiconductor board 3 as shown in the drawing. Then, the above-described release film 6a for sealing the semiconductor elements is attached to the lower side of the upper mold half 1. Thereafter, the sealing resin 5 is placed on the center of the semiconductor board 3. The board installation step is thus completed. Fig. 1 illustrates the state in which the board installation step is completed

Then, the resin layer formation step is carried out. In this respect, the upper mold half 1 is moved downward until it comes into contact with the lower mold half side members 2b. With the movement of the upper mold half 1, the release film 6a for sealing semiconductor elements is also moved downward, and compresses the sealing resin 5. The lower mold half base 2a is not moved, and the upper mold half 1 is further moved downward together with the lower mold half side members 2b. Consequently, the sealing resin 5 is compressed and spread out to the outer periphery of the semiconductor board 3, whereby the whole semiconductor board 3 is sealed with the sealing resin. After that, the inside of the mold is heated, and the sealing resin 5 is hardened thereby. At the time the resin layer is thus formed, the release film 6a for sealing semiconductor elements compresses the sealing resin 5, and the tips of the projecting electrodes 4 formed on the surface of the semiconductor board 3 are embedded within the sealing resin 5.

The releasing step is next carried out. Initially, the upper mold half 1 is raised and released from the release film 6a for sealing semiconductor elements. Then, the lower mold half side members 2b are slightly lowered while the lower mold half base 2a is not moved, so that the resin layer is released from the lower mold half side members 2b. After that, the lower mold half side members 2b are raised. As a result, the semiconductor board 3, on which the resin layer is formed, is released, together with the release film 6a for sealing semiconductor elements, from the lower mold half base 2a. The releasing step is completed with these procedures. The next steps are the projection electrodes exposure step and the separation step. These steps may be carried out in known manners.

In the above explanation, the release film is placed only on the lower side of the upper mold half 1, another release film 6b may be further provided between the lower mold half base 2a and the semiconductor board 3. This gives an advantage of facilitating the releasing step in which the semiconductor board 3, on which the resin layer is formed, is released, together with the release film 6a for sealing semiconductor elements, from the lower mold half base 2a.

The present invention will hereinbelow be described in further detail with reference to the following examples.

The evaluation methods and the way of experiments as used in the following examples and comparative examples are as follows.

### Evaluation methods

### (1) wetting index

The wetting index was measured according to the method defined in JIS (Japanese Industrial Standards) K6768, using a wetting index standard solution (available from Wako Pure Chemical Industries, Ltd.).

### (2) heat shrinkage rate

Films were allowed to stand in an oven heated at 175°C under no load for 150 minutes, and then the heat shrinkage rates of the films were measured.

### (3) modulus of elasticity

The film stretching test was conducted under an atmosphere at 175°C, and the modulus of elasticity values of the films subjected to the test were measured.

### Experiments on sealing semiconductor elements

After pressing was performed at 175°C for 150 minutes, using the mold shown in Fig. 1, the wafer was taken out from the mold in such a manner that the release film was stuck to the wafer, and was allowed to cool to room temperature. After that, the release film was peeled off from the wafer, and the releasability of the film and the deformation of the bumps (i.e., the projecting electrodes) formed on the wafer were observed.

### Production of release films

Materials used:
(1) syndiotactic polystyrene 1
   Mw = 270,000; Mw/Mn = 2.20 (as measured at 150°C according to GPC method, using 1, 2, 4-trichlorobenzene as a solvent)
(2) syndiotactic polystyrene 2
   Mw = 100,000; Mw/Mn = 2.20 (as measured at 150°C according to GPC method, using 1, 2, 4-trichlorobenzene as a solvent)
(3) polystyrene (GPPS)
   HH30 available from Idemitsu Petrochemical Co., Ltd.
(4) rubber-like elastic material 1
   a SEPT type elastomer: SEPTON 2104 available from KURARAY Co., Ltd.
(5) rubber-like elastic material 2
   an ethylene-octene copolymer elastomer: ENGAGE 8150 available from DuPont · Dow Elastomer Corporation
(6) thermoplastic resin 1
   poly(4-methylpentene-1): MX 0002 available from Mitsui Chemical Co., Ltd.
(7) antioxidant 1
   Irganox 1010 available from Ciba Geigy Corporation
(8) antioxidant 2
   PEP 36 available from ASAHI DENKA KOGYO K.K.

### Example 1

Pellets were obtained by dry-blending 80 parts by weight of the syndiotactic polystyrene 1, 4 parts by weight of the rubber-like elastic material 1, 16 parts by weight of the rubber-like elastic material 2, 0.1 part by weight of the antioxidant 1 and 0.1 part by weight of the antioxidant 2 to obtain a styrene polymer composition having a syndiotactic structure (i.e., SPS composition), and melting and kneading it, using a twin-screw extruder having a diameter of 65 mm. These pellets were melted and extruded at 300°C at an extrusion rate of 20 kg/hour, using a single-screw extruder having a diameter of 50 mm to which a coathanger type die having a width of 500 mm was mounted, whereby a film having a thickness of 100 µm was obtained. The obtained film, that is, a release film, was subjected to the above-described film evaluation tests, and the sealing experiments were conducted using the obtained film. The results are shown in Table 1.

### Example 2

SPS composition as described in Example 1 and the thermoplastic resin 1 (hereinafter referred to as TRX) were co-extruded, thereby to obtain a film having a thickness of 100 µm, with the proportions of thickness of SPS/TPX/SPS being 25/50/25. This film was subjected to the evaluation tests in the same manner as in Example 1. The results of the evaluation tests were shown in Table 1.

### Example 3

The evaluation tests similar to those in Example 1 were performed for a release film, having a thickness of 100 µm, which was made of a fluorine resin, specifically, polytetrafluoroethylene resin (Afluon COP available from Asahi Glass Co., Ltd.). The results of the evaluation tests were shown in Table 1.

### Comparative Example 1

The evaluation tests similar to those in Example 1 were performed for a release film, which was prepared by subjecting the release film obtained in Example 1 to corona treatment. The results of the evaluation tests were shown in Table 1.

### Comparative Example 2

The evaluation tests similar to those in Example 1 were performed for a release film, which was prepared by bi-axially stretching the film obtained in Example 1 to 1.1 times the initial dimensions in both MD and TD directions under an atmosphere at 120°C, using a table tenter. The results of the evaluation tests were shown in Table 1.

### Comparative Example 3

Pellets were obtained by dry-blending 50 parts by weight of the syndiotactic polystyrene 2, 10 parts by weight of polystyrene (GPPS), 20 parts by weight of the rubber-like elastic material 1, 20 parts by weight of the rubber-like elastic material 2, 0.1 part by weight of the antioxidant 1 and 0.1 part by weight of the antioxidant 2, and melting and kneading the blended mixture, using a twin-screw extruder having a diameter of 65 mm. The evaluation tests similar to those in Example I were performed for the film produced using the obtained pellets. The results of the evaluation tests were shown in Table 1.

### Comparative Example 4

The evaluation tests similar to those in Example 1 were performed for a polyimide film (Kapton H available from DuPont Corporation) having a thickness of 100 µm. The results of the evaluation tests were shown in Table 1.

**TABLE 1**

| | Ex. 1 | Ex. 2 | Ex. 3 | Com. Ex. 1 | Com. Ex. 2 | Com. Ex. 3 | Com. Ex. 4 |
|---|---|---|---|---|---|---|---|
| Wetting index | 33 | 33 | Not greater than 20 | 50 | 32 | 33 | Not greater than 20 |
| Heat shrinkage rate (%) | 0.6 | 1.5 | Not greater than 0.5 | 0.6 | 3.5 | 5 | Not greater than 0.5 |
| Modulus of elasticity (MPa) | 80 | 60 | 50 | 80 | 130 | 8 | Not less than 1000 |
| Film thickness (µm) | 100 | 100 | 100 | 100 | 83 | 100 | 100 |
| Releasability | Good | Good | Good | The film was broken when it was released from the mold. | The film was stuck to the mold, and did not go with the device. | The film was stretched, and the device could not be taken out. | Good |
| Deformation of bumps | No deformation | No deformation | No deformation | No deformation | No deformation | ― | Deformed |

### INDUSTRIAL APPLICABILITY

The release film for sealing semiconductor elements according to the present invention is the one which neither deforms nor causes deformation of the terminals of the semiconductors and which has good releasability during the semiconductor elements sealing process. If semiconductors are produced, using such release films, efficiency of manufacturing semiconductors can be improved.

## Claims

1. A mold release film for sealing a semiconductor element, comprising a single layer or a plurality of layers containing a thermoplastic resin, and satisfying the following (1)-(4) requirements:
(1) a wetting index of a surface layer of the mold release film is 36 or less;
(2) a heat shrinkage rate of the mold release film at 175°C is less than 3 percent;
(3) a modulus of elasticity of the mold release film at 175°C is in the range of 10-500 MPa; and
(4) a thickness of the mold release film is in the range of 10-300 µm.

2. A mold release film for sealing a semiconductor element according to claim 1, wherein at least a front surface layer of the mold release film comprises (A) a fluorine resin, (B) a styrene polymer having predominantly a syndiotactic structure or (C) a resin composition containing a styrene polymer having predominantly a syndiotactic structure.

3. A mold release film for sealing a semiconductor element according to claim 2, wherein (C) the resin composition containing a styrene polymer having predominantly a syndiotactic structure comprises 50 wt.% or more but less than 100 wt.% of a styrene polymer having predominantly a syndiotactic structure, and not greater than 50 wt.% but more than 0 wt.% of at least one component selected from the group consisting of (C-1) a rubber-like elastic material, (C-2) a thermoplastic resin other than the styrene polymer having predominantly a syndiotactic structure and (C-3) an additive for the resin composition.

4. A sealing method for a semiconductor element comprising placing a semiconductor board, on which the semiconductor element with projecting electrodes is mounted, in a semiconductor production mold in which at least one mold release film is arranged, and thereafter supplying a sealing resin to the mold to carry out compression molding, wherein the mold release film for sealing the semiconductor element according to any one of claims 1-3 is used as the at least one mold release film arranged in the mold.
